(19) Europäisches Patentamt
European Patent Office
Office européen des brevets

(11) **EP 2 894 012 B1**

(12) **EUROPEAN PATENT SPECIFICATION**

(45) Date of publication and mention
of the grant of the patent:
**11.07.2018 Bulletin 2018/28**

(21) Application number: **12884215.0**

(22) Date of filing: **04.09.2012**

(51) Int Cl.:
*B25J 13/08* [(2006.01)]  *H05K 13/04* [(2006.01)]
*B25J 9/00* [(2006.01)]  *B25J 9/02* [(2006.01)]
*H05K 13/08* [(2006.01)]

(86) International application number:
**PCT/JP2012/072472**

(87) International publication number:
**WO 2014/037993 (13.03.2014 Gazette 2014/11)**

(54) **WORK DEVICE**

ARBEITSVORRICHTUNG

DISPOSITIF DE TRAVAIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.07.2015 Bulletin 2015/29**

(73) Proprietor: **Fuji Machine Mfg. Co., Ltd.**
**Chiryu-shi**
**Aichi 472-8686 (JP)**

(72) Inventors:
• **IWAKI Noriaki**
**Chiryu-shi**
**Aichi 472-8686 (JP)**

• **DEGURA Kazunari**
**Chiryu-shi**
**Aichi 472-8686 (JP)**

(74) Representative: **Grünecker Patent- und Rechtsanwälte**
**PartG mbB**
**Leopoldstraße 4**
**80802 München (DE)**

(56) References cited:
**EP-A1- 0 302 475**   **EP-A1- 2 126 645**
**DE-A1- 3 805 784**   **JP-A- H01 227 499**
**JP-A- 2003 028 615**  **JP-A- 2004 336 963**
**JP-A- 2004 336 963**  **JP-A- 2008 166 410**
**JP-A- 2010 099 597**  **JP-B2- 3 247 703**
**JP-B2- 3 247 703**

EP 2 894 012 B1

**Description**

Technical Field

The present invention relates to a work apparatus that includes first and second robots capable of moving relative to a body in an X direction and a Y direction.

Background Art

In the past, there has been proposed a printed circuit board-work apparatus that includes a robot movable relative to a body in an X direction and a Y direction and performs the application of an adhesive to a printed circuit board, the mounting of an electronic component on the printed circuit board, the inspection of the printed circuit board, and the like by a work device mounted on the robot as disclosed in PTL 1. Manufacturing errors and assembly errors of components of the printed circuit board-work apparatus, errors caused by temporal changes, and various errors generally arise in such a printed circuit board-work apparatus. For this reason, the feeding accuracy of the robot relative to the body is lowered and working accuracy is lowered. In order to solve this problem, PTL 1 discloses a technique that images reference marks of a reference plate held to the body by an imaging device mounted on the robot, detects the feeding errors of the robot, and automatically corrects the feeding errors of the robot. PTL 2 discloses the preamble of claim 1.

Citation List

Patent Literature

PTL 1: Japanese Patent No. 3247703
PTL 2: DE 38 05 784 A1

Summary of Invention

Technical Problem

In recent years, there has been proposed a printed circuit board-work apparatus including a second robot that is provided on a body at a position different from a position of a robot (hereinafter, referred to as a first robot) in a Z direction and can move in an X direction and a Y direction. In the technique disclosed in the above-mentioned PTL 1, the feeding errors of the first robot can be detected but the feeding errors of the second robot cannot be detected.
The invention has been made in consideration of the circumstances, and provides a work apparatus that can detect feeding errors of a second robot provided at a position different from a position of a first robot in a Z direction.

Solution to Problem

To solve the above problem, the present invention provides the work apparatus according to claim 1
As described above, the relative position detecting means moves the first and second robots to the inspection positions in the X direction and the Y direction and detects the relative position errors of the first and second robots on the basis of the inspection marks that are imaged at the inspection positions by the imaging device, and the second robot-feeding error detecting means detects the second robot-feeding errors relative to the body on the basis of the first robot-feeding errors and the relative position errors that have been already detected. For this reason, it is possible to provide the work apparatus that can detect feeding errors of the second robot provided at the position different from the position of the first robot in the Z direction.
According to an invention of claim 2, in claim 1, the inspection positions are grid points on a plane parallel to the X direction and the Y direction, the relative position detecting means detects the relative position errors at a plurality of grid points among all the grid points, and the second robot-feeding error detecting means detects the second robot-feeding errors on the basis of a plurality of the relative position errors that are detected at the plurality of grid points.
As described above, the second robot-feeding errors are detected on the basis of the relative position errors that are detected at the plurality of grid points. That is, it is possible to acquire highly accurate second robot-feeding errors at a work position by calculating the second robot-feeding errors at the work position on the basis of relative position errors that are detected at a plurality of grid points present in the vicinity of the work position where a work device mounted on the second robot actually performs work.

According to an invention of claim 3, in claim 1, the relative position detecting means detects the relative position errors at a work position of the second work device that is mounted on the second robot, and the second robot-feeding error detecting means detects the second robot-feeding errors on the basis of the relative position errors that are detected at the work position.

Since the relative position errors are detected at the work position where the work device mounted on the second robot actually performs work and the second robot-feeding errors are calculated on the basis of the relative position errors as described above, it is possible to acquire highly accurate second robot-feeding errors at the work position.

According to an invention of claim 4, in any one of claims 1 to 3, the reference marks are marks that are formed in the shape of grid points on a surface of a reference plate disposed on the body in parallel to the X direction and the Y direction, and the first robot-feeding error detecting means detects the first robot-feeding errors on the basis of information about the positions of the plurality of reference marks among all the reference marks.

Since the first robot-feeding errors are detected on the basis of the reference marks that are imaged at the plurality of grid points as described above, it is possible to acquire highly accurate first robot-feeding errors. As a result, it is possible to acquire highly accurate second robot-feeding errors.

Brief Description of Drawings

[Fig. 1] Fig. 1 is a top view of a printed circuit board-work apparatus of an embodiment.
[Fig. 2] Fig. 2 is a view seen in a direction of an arrow A of Fig. 1, and is a front view of the printed circuit board-work apparatus of this embodiment.
[Fig. 3] Fig. 3 is a block diagram of the printed circuit board-work apparatus.
[Fig. 4] Fig. 4 is a flowchart of processing that is performed by a controller of the printed circuit board-work apparatus.
[Fig. 5] Fig. 5 is a view showing a reference plate that is used for matrix correction.
[Fig. 6] (A) is a view illustrating a method of calculating position errors when the reference plate is held at an inspection position. (B) is a view illustrating a relationship among a position error that arises at reference marks provided on the reference plate, a feeding error, and a value that is measured by an imaging device.
[Fig. 7] Fig. 7 is a view illustrating an inspection position when normal calibration is performed.
[Fig. 8] Fig. 8 is a view illustrating a method of calculating lower robot-feeding errors.

Description of Embodiments

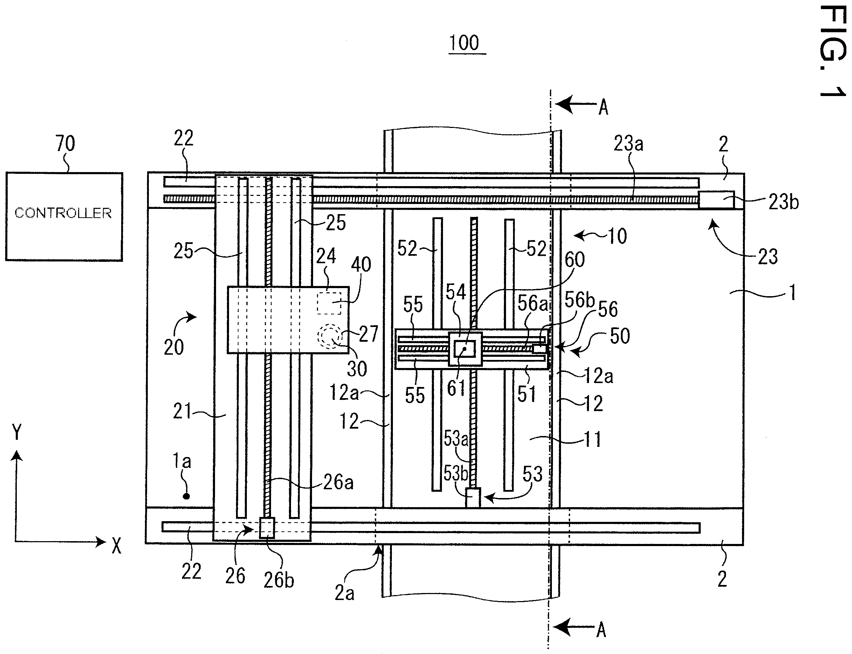

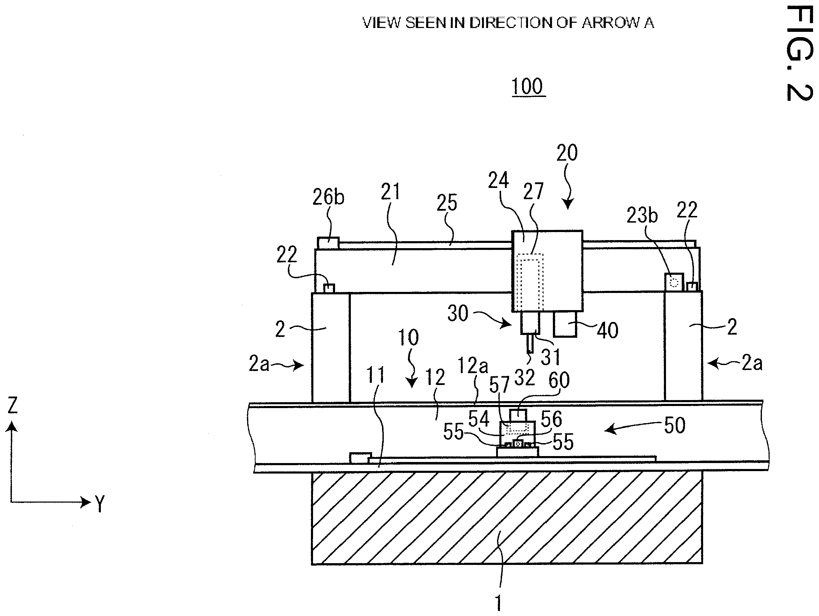

(Description of structure of printed circuit board-work apparatus) The structure of a printed circuit board-work apparatus 100 of an embodiment will be described below with reference to Figs. 1 and 2. Meanwhile, the longitudinal direction of the printed circuit board-work apparatus 100 is referred to as an X direction. Further, the width direction of the printed circuit board-work apparatus 100, that is, a direction orthogonal to the X direction is referred to as a Y direction. Furthermore, the vertical direction of the printed circuit board-work apparatus 100, that is, a direction orthogonal to the X direction and the Y direction is referred to as a Z direction.

The printed circuit board-work apparatus 100 is for mounting an electronic component on a printed circuit board in this embodiment. As shown in Figs. 1 and 2, the printed circuit board-work apparatus 100 includes a base 1, a pair of support walls 2, a conveyor unit 10, an upper robot 20, an upper work device 30, an imaging device 40, a lower robot 50, a lower work device 60, and a controller 70.

The base 1 has the shape of a pedestal. The pair of support walls 2 are provided on the base 1 along both side edges of the base 1 (in the X direction). Meanwhile, a window 2a is formed at each of the support walls 2. As shown in Fig. 1, a body origin 1a is provided on the base 1. The body origin 1a is, for example, a circular mark.

The conveyor unit 10 is provided on the base 1 so as to pass through the windows 2a of the pair of support walls 2. The conveyor unit 10 conveys a printed circuit board to the printed circuit board-work apparatus 100 from a device of a previous process of the printed circuit board-work apparatus 100, and conveys the printed circuit board, on which work has been completed in the printed circuit board-work apparatus 100, to a post process of the printed circuit board-work apparatus 100. The conveyor unit 10 includes a body 11, conveyors 12, and a clamping unit (not shown).

The body 11 has the shape of a plate or a block. The body 11 passes through the windows 2a of the pair of support walls and is positioned and mounted on the base 1.

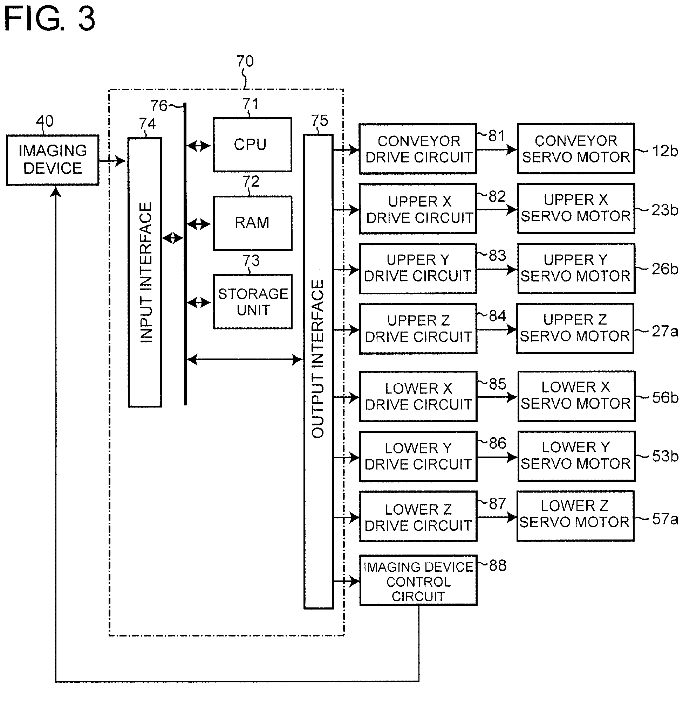

The conveyors 12 are provided at both side ends of the body 11 along the longitudinal direction (Y direction) of the body 11. Each of the conveyors 12 includes an endless belt 12a that is driven by a conveyor servo motor 12b (see Fig. 3) so as to be rotated. A printed circuit board is placed on the pair of belts 12a that are driven so as to be rotated. The printed circuit board is moved in the Y direction by these belts 12a, and is sequentially moved to a previous process, a "holding

position" in the printed circuit board-work apparatus 100, and a post process. The clamping unit clamps the printed circuit board, which is conveyed to the "holding position", together with the belts 12a by pressing the printed circuit board downward from above, and holds the printed circuit board at the "holding position". Electronic components are mounted on the printed circuit board at the "holding position" by the upper work device 30 and the lower work device 60.

The upper robot 20 includes an X moving body 21, a pair of X guides 22, an X-moving device 23, a Y moving body 24, a pair of Y guides 25, a Y-moving device 26, and a Z moving device 27.

The pair of X guides 22 are provided at the upper ends of the support walls 2 so as to extend in the X direction. The X moving body 21 is slidably mounted on the pair of X guides 22. For this reason, the X moving body 21 can be moved in the X direction. The X-moving device 23 moves the X moving body 21 in the X direction, and includes a ball screw 23a and an upper X servo motor 23b. The ball screw 23a is threadedly engaged with the X moving body 21. The upper X servo motor 23b rotates the ball screw 23a. When the ball screw 23a is rotated by the upper X servo motor 23b, the X moving body 21 is moved in the X direction.

The pair of Y guides 25 are provided on the X moving body 21 so as to extend in the Y direction. The Y moving body 24 is slidably mounted on the pair of Y guides 25. For this reason, the Y moving body 24 can be moved in the Y direction. The Y-moving device 26 moves the Y moving body 24 in the Y direction, and includes a ball screw 26a and an upper Y servo motor 26b. The ball screw 26a is threadedly engaged with the Y moving body 24. The upper Y servo motor 26b rotates the ball screw 26a. When the ball screw 26a is rotated by the upper Y servo motor 26b, the Y moving body 24 is moved in the Y direction.

The upper work device 30 is mounted on the Y moving body 24 so as to be movable in the Z direction. The Z moving device 27 moves the upper work device 30 in the Z direction, and includes a ball screw (not shown) that is threadedly engaged with the upper work device 30 and an upper Z servo motor 27a (see Fig. 3) that rotates the ball screw.

The upper work device 30 is a suction head that sucks an electronic component in this embodiment, and includes a nozzle holder 31 that is mounted on the Y moving body 24 so as to be movable in the Z direction and a suction nozzle 32 that is detachably mounted on the lower end of the nozzle holder 31.

The imaging device 40 is mounted on the Y moving body 24. The imaging device 40 images the lower side, that is, the side where the lower robot 50 or the lower work device 60 to be described below is present. The imaging device 40 includes an imaging element, such as a CCD or a CMOS, and a single or a plurality of lenses that form a subject image on the imaging element. The imaging device 40 originally detects the position of a board mark that is provided on the printed circuit board positioned at the "holding position". Meanwhile, the position of the upper robot 20 relative to the printed circuit board, when an electronic component sucked by the suction nozzle 32 is mounted on the printed circuit board, is corrected on the basis of the position of the board mark.

The lower robot 50 includes a Y moving body 51, a pair of Y guides 52, a Y-moving device 53, an X moving body 54, a pair of X guides 55, an X-moving device 56, and a Z moving device 57.

The pair of Y guides 52 are provided on the body 11 of the conveyor unit 10 so as to extend in the Y direction. The Y moving body 51 is slidably mounted on the pair of Y guides 52. For this reason, the Y moving body 51 can be moved in the Y direction. The Y-moving device 53 moves the Y moving body 51 in the Y direction, and includes a ball screw 53a and a lower Y servo motor 53b. The ball screw 53a is threadedly engaged with the Y moving body 51. The lower Y servo motor 53b rotates the ball screw 53a. When the ball screw 53a is rotated by the lower Y servo motor 53b, the Y moving body 51 is moved in the Y direction.

The pair of X guides 55 are provided on the Y moving body 51 so as to extend in the X direction. The X moving body 54 is slidably mounted on the pair of X guides 55. For this reason, the X moving body 54 can be moved in the X direction. The X-moving device 56 moves the X moving body 54 in the X direction, and includes a ball screw 56a and a lower X servo motor 56b. The ball screw 56a is threadedly engaged with the X moving body 54. The lower X servo motor 56b rotates the ball screw 56a. When the ball screw 56a is rotated by the lower X servo motor 56b, the X moving body 54 is moved in the X direction.

The lower work device 60 is mounted on the X moving body 54 so as to be movable in the Z direction. The Z moving device 57 moves the lower work device 60 in the Z direction, and includes a ball screw (not shown) that is threadedly engaged with the lower work device 60 and a lower Z servo motor 57a (see Fig. 3) that rotates the ball screw.

In this embodiment, the lower work device 60 is a cut-and-clinch device for cutting a lead of an electronic component, which is mounted on the printed circuit board, to a desired length while bending the lead below the printed circuit board. The lower work device 60 is provided with an inspection mark 61. The inspection mark 61 is, for example, a circular mark. In this embodiment, a position on the lower work device 60 where the lower work device 60 performs work corresponds to the inspection mark 61.

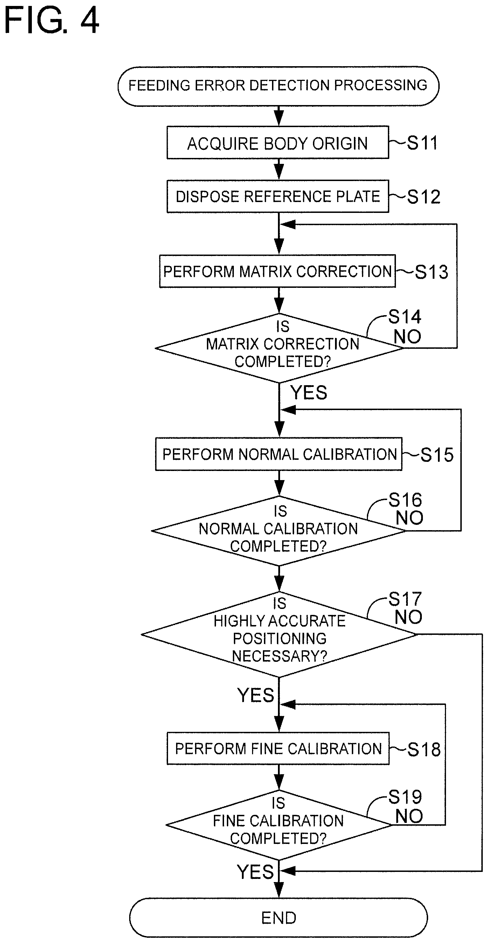

(Description of block diagram of printed circuit board-work apparatus) The block diagram of the printed circuit board-work apparatus 100 will be described below with reference to Fig. 3. The printed circuit board-work apparatus 100 is controlled by the controller 70. The controller 70 includes a CPU 71, a RAM 72, a storage unit 73, and a bus 76 that connects these. The CPU 71 executes a program corresponding to a flowchart illustrated in Fig. 4. The RAM 72 temporarily stores variables that are required for the execution of the program. The storage unit 73 is formed of a nonvolatile memory or the like, and stores the program and stores various errors to be described below.

The controller 70 includes an input interface 74 and an output interface 75 that are connected to the bus 76. The imaging device 40 is connected to the input interface 74. A conveyor drive circuit 81, an upper X drive circuit 82, an upper Y drive circuit 83, an upper Z drive circuit 84, a lower X drive circuit 85, a lower Y drive circuit 86, a lower Z drive circuit 87, and an imaging device control circuit 88 are connected to the output interface 75. The conveyor servo motor 12b, the upper X servo motor 23b, the upper Y servo motor 26b, the upper Z servo motor 27a, the lower X servo motor 56b, the lower Y servo motor 53b, and the lower Z servo motor 57a are connected to the conveyor drive circuit 81, the upper X drive circuit 82, the upper Y drive circuit 83, the upper Z drive circuit 84, the lower Y drive circuit 86, and the lower Z drive circuit 87, respectively.

The drive circuits 81 to 87 rotate the servo motors 12b, 23b, 26b, 27a, 56b, 53b, and 57a to instruction values, respectively, by supplying drive currents to the servo motors 12b, 23b, 26b, 27a, 56b, 53b, and 57a on the basis of the instruction values that are output from the controller 70. Meanwhile, the conveyor drive circuit 81 drives the servo motors and operates the clamping unit by supplying drive currents to the servo motors that drive the clamping unit of the conveyors 12.

The imaging device control circuit 88 is connected to the imaging device 40. The imaging device control circuit 88 allows the imaging device 40 to perform imaging by controlling the imaging device 40 on the basis of an "imaging instruction" that is output from the controller 70. "Imaging data", which are taken by the imaging device 40, are stored in the RAM 72 through the input interface 74.

(Feeding error detection processing) "Feeding error detection processing" will be described below with reference to a flowchart illustrated in Fig. 4. When the flow of "feeding error detection processing" starts, the controller 70 acquires the "body origin" in S11. Specifically, the controller 70 moves the imaging device 40 to a position above the body origin 1a by driving the upper X servo motor 23b and the upper Y servo motor 26b. Next, the controller 70 acquires "imaging data", which include the body origin 1a, by allowing the imaging device 40 to image the body origin 1a. Next, the controller 70 acquires the X coordinate and the Y coordinate of the body origin 1a through calculation on the basis of the "imaging data" including the body origin 1a. The controller 70 recognizes a program origin, which is used to move the upper and lower robots 20 and 50, by the processing of S11. When S11 ends, the program proceeds to S12.

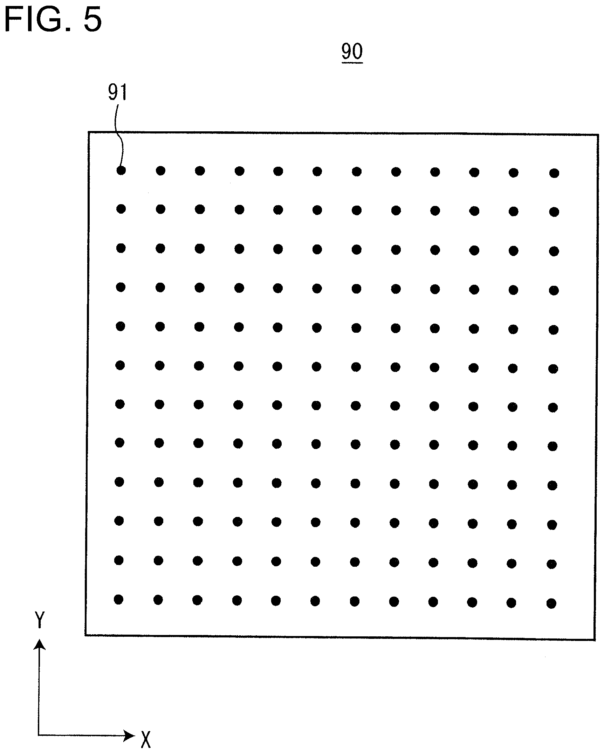

In S12, the controller 70 conveys a reference plate 90, which is shown in Fig. 5, to an "inspection position", which is present substantially in the middle of the printed circuit board-work apparatus 100 in the Y direction, by the conveyors 12, and positions and holds the reference plate 90 at the "inspection position" by the clamping unit. The reference plate 90 is a plate on which circular reference marks 91 are provided at grid points as shown in Fig. 5. In other words, the reference marks 91 are provided on the surface of the reference plate 90 so as to correspond to a plurality of rows in the X direction and a plurality of columns in the Y direction. When S12 ends, the program proceeds to S13.

In S13, the controller 70 performs "matrix correction". Specifically, the controller 70 moves the imaging device 40 to a position above each reference mark 91 of the reference plate 90 by operating the upper X servo motor 23b and the upper Y servo motor 26b, and sequentially acquires the "imaging data", which include the respective reference marks 91, by sequentially imaging the respective reference marks 91. Meanwhile, in the following description, a row number is denoted by i and a column number is denoted by j . For example, the coordinates of the reference mark 91, which corresponds to the i-th row and the j-th column, are represented by $(x_{i,j}, y_{i,j})$.

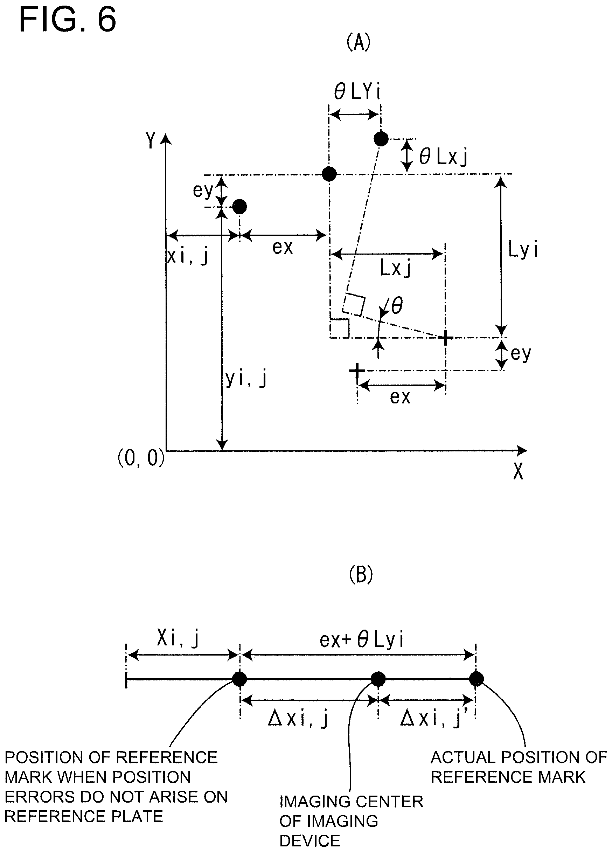

When the controller 70 holds the reference plate 90 at the "inspection position" on the conveyors 12 to acquire the reference marks 91, the "position errors" of the reference plate 90 relative to the conveyors 12 generally arise. The "position errors" arise in the X direction, in the Y direction, and around an axis parallel to the Z direction. When a deviation of $e_x$ arises in the X direction, a deviation of $e_y$ arises in the Y direction, and a deviation of an angle $\theta$ arises around an axis at the center of the reference plate 90 as shown in Fig. 6(A), the amount of the deviation in the X direction and the amount of the deviation in the Y direction, which arise by rotation at a point distant from the center in the X direction and the Y direction by $L_x$ and $L_y$, are $\theta L_y$ and $\theta L_x$ and the coordinates of an arbitrary point on the reference plate 90 become $(x+e_x+\theta L_y, y+e_y+\theta L_x)$ assuming that the coordinates of the arbitrary point are $(x,y)$ when the "position errors" do not arise.

Accordingly, when the reference mark 91, which corresponds to the i-th row and the j-th column, is imaged by the movement of the imaging device 40 in the X direction, the reference mark 91 deviates from the position $x_{i,j}$ ("movement-instruction data" represents this value), which is obtained when the "position errors" do not arise, in the X direction by $(e_x+\theta L_{yi})$ as shown in Fig. 6(B). The amount of the deviation of the reference mark is the sum of a feeding error $\Delta x_{i,j}$ of the imaging device 40, which is obtained when the reference mark 91 is imaged, and a measured value $\Delta x_{i,j}'$ that is obtained by the imaging of the imaging device 40. Meanwhile, when the reference mark 91, which corresponds to the i-th row and the j-th column, is imaged by the movement of the reference plate 90 in the Y direction, the reference mark 91 deviates from the position, which is obtained when the "position errors" do not arise, in the Y direction by $(e_y+\theta L_{xj})$. The amount of the deviation of the reference mark is equal to the sum of a feeding error $\Delta y_{i,j}$ of the reference plate 90 and a measured value $\Delta y_{i,j}'$ that is obtained by the imaging of the imaging device 40.

Next, the detection of the "feeding errors" of the upper X servo motor 23b and the upper Y servo motor 26b will be described in detail. First, the controller 70 calculates deviations Δxi,j',Δyi,j' between the imaging center of the imaging device 40 and the center of the reference mark 91 on the basis of the "imaging data" including each reference mark 91. Next, the controller 70 calculates the position errors ex, ey, and θ of the reference plate 90. This calculation is performed as described below. For example, when the reference mark 91 corresponding to the i-th row and the j-th column is imaged by the movement of the imaging device 40 in the X direction, Expression (1) is satisfied about the reference mark 91.

$$\Delta xi,j + \Delta xi,j' = ex + \theta Lyi \ \ldots \ (1)$$

Further, Expression (2) is obtained about the reference mark 91 that corresponds to the i-th row and the (j+1)-th column.

$$\Delta xi,(j+1) + \Delta xi,(j+1)' = ex + \theta Lyi \ \ldots \ (2)$$

Furthermore, Expression (3) is obtained about a distance between a reference mark 91 that corresponds to the i-th row and the j-th column and a reference mark 91 that corresponds to the i-th row and the (j+1)-th column.

$$xi,(j+1) + \Delta xi,(j+1) + \Delta xi,(j+1)' - (xi,j + \Delta xi,j + \Delta xi,j') = P \ \ldots \ (3)$$

P is a distance between the reference marks 91 that are adjacent to each other in the X direction, and is also a distance between the reference marks 91 that are adjacent to each other in the Y direction. Further, Expressions (4) and (5) are obtained from the imaging result of a reference mark 91 that corresponds to the i-th row and the (j+2)-th column.

$$\Delta xi,(j+2) + \Delta xi,(j+2)' = ex + \theta Lyi \ \ldots \ (4)$$

$$xi,(j+2) + \Delta xi,(j+2) + \Delta xi,(j+2)' - (xi,(j+1) + \Delta xi,(j+1) + \Delta xi,(j+1))' = P \ \ldots \ (5)$$

There are five unknowns of the above-mentioned five expressions, that is, Δxi,j, Δxi,(j+1), Δxi,(j+2), ex, and θ, and these unknowns can be calculated from the five expressions . These five expressions are obtained by the imaging of three reference marks 91 that are adjacent to each other in the X direction. When unknowns are calculated for each of the three reference marks, two values of ex and two values of θ are calculated per row. Further, expressions can also be obtained likewise from the reference marks 91 that are lined up in the Y direction, and two values of ey and two values of θ are calculated per column. The calculation of these position errors ex, ey, and θ may be performed for both of data at the time of movement in a normal direction and data at the time of movement in a reverse direction, and may be performed for any one thereof.

Next, the controller 70 calculates mean values of the plurality of obtained ex, ey, and θ, and stores the mean values in the RAM 72 as mean position errors exm, eym, and θm. After that, the controller 70 substitutes the mean position errors exm, eym, and θm for ex, ey, and θ of the expressions of "Δxi,j+Δxi,j'=ex+θLyi" and "Δyi,j+Δyi,j'=ey+θLxj" that are satisfied among the "position error", the "feeding error", and the measured value; and calculates Δxi,j and Δyi,j.

Two values, that is, a feeding error at the time of movement in the normal direction and a feeding error at the time of movement in the reverse direction are obtained for each reference mark 91 as the "feeding error"; and are stored in the RAM 72 in association with "movement-instruction data", which is obtained when each reference mark 91 is imaged, and the feed directions of the imaging device 40 and the reference plate 90. All the reference marks 91 belong to rows parallel to an X axis and columns parallel to a Y axis. A total of four "feeding errors", that is, two kinds of feeding errors, which are obtained when one reference mark 91 is imaged by the movement of the imaging device 40 in both the normal direction and the reverse direction as a reference mark belonging to the row parallel to the X axis, and two kinds of feeding errors, which are obtained when the reference mark 91 is imaged by the movement of a Y-axis table 34 in both the normal direction and the reverse direction as a reference mark belonging to the column parallel to the Y axis, are stored. Next, the controller 70 calculates "upper robot-feeding errors", which are "feeding errors" of the upper robot 20 relative to the base 1 in the X direction and the Y direction, by averaging all the calculated "feeding errors".

If the controller 70 determines that the "matrix correction" is completed in S14 (YES in S14), the controller 70 allows the program to proceed to S15. If the controller 70 determines that the "matrix correction" is not completed in S14 (NO in S14), the controller 70 allows the program to return to S13.

In S15, the controller 70 performs "normal calibration". Specifically, the controller 70 moves the imaging center of the imaging device 40 and the inspection mark 61 to an "inspection position" common to the X direction and the Y direction by operating the upper robot 20 and the lower robot 50. Further, the controller 70 images the inspection mark 61 by the imaging device 40 and acquires "imaging data" including the inspection mark 61. Next, the controller 70 calculates "relative position errors" of the upper robot 20 and the lower robot 50 in the X direction and the Y direction on the basis of the "imaging data" including the inspection mark 61. Specifically, the controller 70 calculates deviations between the imaging center of the imaging device 40 and the center of the inspection mark 61 in the X direction and the Y direction on the basis of the "imaging data" including the inspection mark 61, and calculates the deviations as "relative position errors".

Meanwhile, since the "feeding errors" of the upper robot 20 have been already corrected by the "matrix correction" of S13, the imaging center of the imaging device 40 is accurately positioned at the "inspection position" without an error between the "instruction value", which is output from the controller 70 and allows the upper robot 20 to be moved to the "inspection position", and an actual feed position of the upper robot 20. On the other hand, before the "normal calibration" is performed, there is an error between an "instruction value" , which is output from the controller 70 and allows the lower robot 50 to be moved to the "inspection position" , and an actual feed position of the lower robot 50.

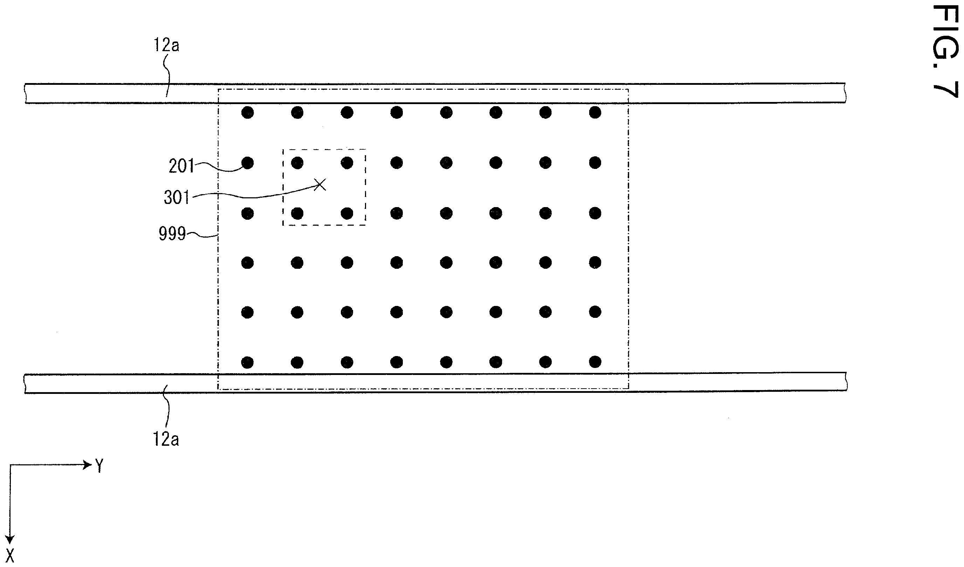

Meanwhile, as shown in Fig. 7, in the "normal calibration", the above-mentioned "inspection position" is each grid point 201 on a plane parallel to the X direction and the Y direction, and a plurality of rows of grid points are set in the X direction and a plurality of columns of grid points are set in the Y direction. When a printed circuit board 999 is held at the "holding position", the grid point 201 is positioned within an area of the printed circuit board 999. That is, the grid points 201, which are the "inspection positions", are positioned in the movable ranges of the upper and lower work devices 30 and 60 when electronic components are mounted on the printed circuit board at the "holding position" by the upper and lower work devices 30 and 60. Meanwhile, the coordinates of the grid point 201, which corresponds to the i-th row and the j-th column, is represented by $(X_{i,j}, Y_{i,j})$. Of course, when the "normal calibration" is performed, the printed circuit board 999 is not present at the "holding position".

The controller 70 calculates the "relative position errors" at all the grid points 201 that are the "inspection positions", and stores the "relative position errors" in at least one of the RAM 72 and the storage unit 73.

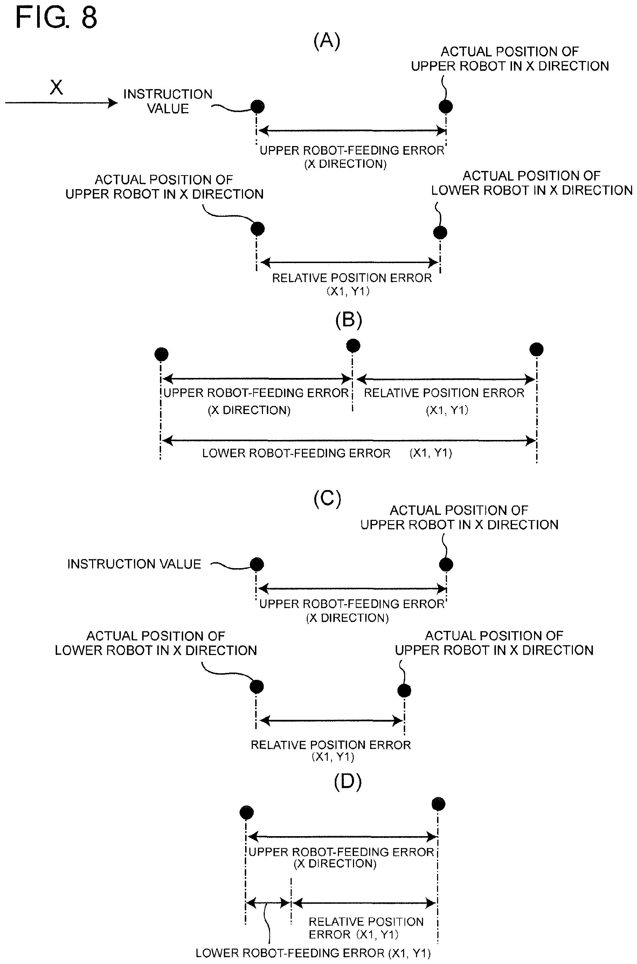

Next, the controller 70 calculates "lower robot-feeding errors", which are "feeding errors" of the lower robot 50 relative to the base 1 in the X direction and the Y direction, on the basis of the "upper robot-feeding errors" and the "relative position errors". As shown in Figs. 8(B) and 8(D), the controller 70 calculates the "lower robot-feeding error" by adding the "relative position error" to the "upper robot-feeding error". When the direction of the "upper robot-feeding error" and the direction of the "relative position error" are different from each other as shown in Fig. 8(C), the controller 70 calculates the "lower robot-feeding error" by adding the "relative position error" of which the direction is opposite to the direction of the "upper robot-feeding error" (in a reverse direction) to the "upper robot-feeding error", that is, by subtracting the absolute value of the "relative position error" from the "upper robot-feeding error".

Fig. 8 illustrates a method of calculating the "lower robot-feeding error" in the X direction, but the controller 70 also calculates the "lower robot-feeding error" in the Y direction by the same method. The controller 70 calculates the "lower robot-feeding errors" at all the grid points 201 and stores the "lower robot-feeding errors" in at least one of the RAM 72 and the storage unit 73.

If the controller 70 determines that the "normal calibration" is completed in S16 (YES in S16), the controller 70 allows the program to proceed to S17. If the controller 70 determines that the "normal calibration" is not completed in S16 (NO in S16), the controller 70 allows the program to return to S15.

If the controller 70 determines that highly accurate positioning is necessary in S17 (YES in S17), the controller 70 allows the program to proceed to S18. If the controller 70 determines that highly accurate positioning is not necessary in S17 (NO in S17), "feeding error detection processing" ends. Meanwhile, for example, when an electronic component is improperly mounted on a printed circuit board or when the setting of the printed circuit board-work apparatus 100 is changed, it is determined that highly accurate positioning is necessary.

In S18, the controller 70 performs "fine calibration". Specifically, the controller 70 moves the imaging center of the imaging device 40 and the inspection mark 61 to a "work position", where the lower work device 60 actually performs work, by operating the upper and lower robots 20 and 50. Further, the controller 70 images the inspection mark 61 by the imaging device 40 and acquires "imaging data" including the inspection mark 61. Next, the controller 70 calculates the "relative position errors" of the upper and lower robots 20 and 50 in the X direction and the Y direction on the basis of the "imaging data" including the inspection mark 61.

Next, the controller 70 calculates "lower robot-feeding errors", which are "feeding errors" of the lower robot 50 relative to the base 1 in the X direction and the Y direction, on the basis of the "upper robot-feeding errors" and the "relative position errors". Meanwhile, a method of calculating the "lower robot-feeding errors" is the same as the case of the above-mentioned "normal calibration". The calculated "lower robot-feeding errors" are stored in at least one of the RAM 72 and the storage unit 73.

If the controller 70 determines that the "fine calibration" is completed in S19 (YES in S19), the "feeding error detection processing" ends. If the controller 70 determines that the "fine calibration" is not completed in S19 (NO in S19), the controller 70 allows the program to return to S18.

(Method of operating lower robot) When only the "normal calibration" is performed in the "feeding error detection processing" illustrated in Fig. 4, the controller 70 calculates "lower robot-feeding errors" at a "work position" on the basis of the "lower robot-feeding errors" that are detected at a plurality of "inspection positions" present in the vicinity of a work position 301 (see Fig. 7) of the lower work device 60. This calculation method is performed by correcting the "lower robot-feeding errors" at the work position 301 from the "lower robot-feeding errors" that are calculated at the respective "inspection positions" (grid points 201 positioned in the area shown by a broken line of Fig. 7) present on both sides of the work position 301 in the X direction and the Y direction. That is, the "lower robot-feeding errors" of the work position 301 are calculated by inversely proportionally distributing the "lower robot-feeding errors" of the grid points 201, which are present on both sides of the work position 301, to distances between the grid points 201, which are present on both sides of the work position 301, and the work position 301.

Further, the controller 70 operates the lower X servo motor 56b and the lower Y servo motor 53b by outputting control signals, in which the "lower robot-feeding errors" are reflected, to the lower X drive circuit 85 and the lower Y drive circuit 86, and moves the lower work device 60 to the work position 301 by operating the lower robot 50.

Meanwhile, when the "fine calibration" is performed in the "feeding error detection processing" illustrated in Fig. 4, the controller 70 operates the lower X servo motor 56b and the lower Y servo motor 53b by outputting control signals, in which the "lower robot-feeding errors" at the "work position" of the lower work device 60 are reflected, to the lower X drive circuit 85 and the lower Y drive circuit 86, and moves the lower work device 60 to the "work position" by operating the lower robot 50.

(Effect of this embodiment) As apparent from the above description, in S15 of Fig. 4, the controller 70 (relative position detecting means) moves the imaging center of the imaging device 40, which is mounted on the upper robot 20 (first robot), and the inspection mark 61 of the lower work device 60, which is mounted on the lower robot 50 (second robot), to the "inspection position" in the X direction and the Y direction. Further, the controller 70 detects the "relative position errors" of the upper and lower robots 20 and 50 on the basis of the inspection mark 61 that is imaged at the "inspection position". Next, the controller 70 (second robot-feeding error detecting means) detects the "lower robot-feeding errors" (second robot-feeding errors) relative to the base 1 (body) on the basis of the "upper robot-feeding errors" (first robot-feeding errors) and the "relative position errors" that have been already detected. For this reason, the "feeding errors" of the lower robot 50, which is provided at a position different from the position of the upper robot 20 in the Z direction, can be detected.

In this embodiment, the controller 70 images the inspection mark 61 of the lower work device 60 by using the existing imaging device 40 that detects the position of the board mark provided on the printed circuit board, and detects the "relative position errors". For this reason, it is possible to detect the "lower robot-feeding errors" by only providing the inspection mark 61 on the lower work device 60 and adding the program of the "feeding error detection processing" illustrated in Fig. 4. Accordingly, it is possible to easily provide the printed circuit board-work apparatus 100, which can detect the "lower robot-feeding errors", at low cost.

Further, in S15 of Fig. 4, the controller 70 calculates the "lower robot-feeding errors" at the "work position" on the basis of the plurality of "lower robot-feeding errors" that are detected at the "inspection positions" present in the vicinity of the "work position" of the lower work device 60. In other words, the controller 70 calculates the "lower robot-feeding errors" at the "work position" on the basis of the "relative position errors" that are detected at the plurality of grid points 201 present in the vicinity of the "work position". As described above, the controller 70 does not calculate the "lower robot-feeding errors" on the basis of a single "relative position error" and calculates the "lower robot-feeding errors" on the basis of the "relative position errors" that are detected at the plurality of grid points 201 present in the vicinity of the "work position" where the lower work device 60 actually performs work. Accordingly, it is possible to acquire highly accurate "lower robot-feeding errors" at the "work position".

Furthermore, in S18 of Fig. 4, the "relative position errors" are detected at the "work position" where the lower work device 60 actually performs work, and the "lower robot-feeding errors" are detected on the basis of the "relative position errors". Accordingly, it is possible to acquire highly accurate "lower robot-feeding errors" at the "work position".

Moreover, in the "matrix correction" of S13 of Fig. 4, the "upper robot-feeding errors" (first robot-feeding errors) are detected on the basis of the reference marks 91 (see Fig. 5) that are imaged at the plurality of grid points. For this reason, as described above, the "position errors" of the reference plate 90 relative to the conveyors 12 in the X direction, in the Y direction, and around an axis parallel to the Z direction can be accurately detected and the "upper robot-feeding errors" are calculated on the basis of the accurate "position errors". Accordingly, it is possible to acquire highly accurate "upper robot-feeding errors". As a result, it is possible to acquire highly accurate "lower robot-feeding errors".

(Other embodiments) In the above-mentioned embodiments, the inspection mark 61 is provided on the lower work device 60. However, the inspection mark 61 may be provided on the X moving body 54 of the lower robot 50.

Meanwhile, when it is difficult to make the position where the lower work device 60 performs work correspond to the inspection mark 61, a pair of inspection marks 61 are provided on the lower work device 60 and a middle position between the pair of inspection marks 61 is made to correspond to the position where the lower work device 60 performs work. In this embodiment, the middle position between the pair of inspection marks 61 is detected by the imaging device 40 in S15 and S18 of Fig. 4 and the "relative position errors" are calculated from deviations between the "middle position" and the imaging center of the imaging device 40.

In the above-mentioned embodiments, in S18 of Fig. 4, the controller 70 moves the imaging center of the imaging device 40 and the inspection mark 61 to the "work position", where the lower work device 60 actually performs work, by operating the upper and lower robots 20 and 50. However, when a position, which is present on the lower work device 60 and at which the lower work device 60 performs work, deviates from the position of the inspection mark 61 in the X direction and the Y direction, the controller 70 moves the imaging center of the imaging device 40 to the position of the inspection mark 61 that is in a state in which the position where the lower work device 60 performs work is moved to the "work position" and performs the "fine calibration".

In the above-mentioned embodiments, the invention has been described using the embodiment in which the "first robot" to be subjected to the "matrix correction" is the upper robot 20 and the "second robot" to be subjected to the "normal calibration" and the "fine calibration" is the lower robot 50. However, the "first robot" may be the lower robot 50 and the "second robot" may be the upper robot 20. In the case of this embodiment, the imaging device 40, which images the side where the upper robot 20 is present, is mounted on the X moving body 54 of the lower robot 50. Further, the reference plate 90 is positioned and held at a position that faces the imaging device 40 of the printed circuit board-work apparatus 100. Furthermore, the inspection mark 61 is provided on the upper work device 30 or the Y moving body 24 of the upper robot 20.

In the above-mentioned embodiments, each of the X-moving devices 23 and 56 and the Y-moving devices 26 and 53 includes the ball screw and the servo motor. However, a linear motor may be used as each of the X-moving devices 23 and 56 and the Y-moving devices 26 and 53.

The upper work device 30 is a suction head in the above-mentioned embodiments. However, the upper work device 30 is not limited thereto, and may be another type of component conveying device, a cream solder applying device, an adhesive applying device, a component mounting-inspection device, or the like. Further, the lower work device 60 is a cut-and-clinch device in the above-mentioned embodiments. However, the lower work device 60 is not limited thereto, and may be, for example, a screw fastening device, a component mounting-inspection device, or the like. In the above-mentioned embodiments, the "work apparatus" including the upper and lower robots 20 and 50 is the printed circuit board-work apparatus 100 that mounts an electronic component on a printed circuit board. However, the "work apparatus" is not limited thereto, and may be, for example, a manufacturing apparatus, such as an apparatus for manufacturing a solar panel.

Reference Signs List

1: base (body), 20: upper robot (first robot), 40: imaging device, 50: lower robot (second robot), 61: inspection mark, 70: controller (first robot-feeding error detecting means, relative position detecting means, second robot-feeding error detecting means), 91: reference mark, 100: printed circuit board-work apparatus (work apparatus), 201: grid point, 301: work position

**Claims**

1. A work apparatus (100) comprising:

   a body (1);
   a first robot (20) that is provided on the body (1) so as to be movable in an X direction and a Y direction orthogonal to each other, wherein a first work device (30) is mounted on the first robot (20);
   a second robot (50) that is provided on the body (1) at a position different from a position of the first robot (20) in a Z direction orthogonal to the X direction and the Y direction so as to be movable in the X direction and the Y direction, wherein a second work device (60) is mounted on the second robot (50),
   wherein the second work device (60) is configured to perform work on an opposite side of a board held by the work apparatus (100) as compared to the first work device (30);
   **characterized by**
   an inspection mark (61) that is provided on the second robot (50) or the second work device (60) mounted on the second robot (50);

an imaging device (40) that is provided on the first robot (20) and images a side where the second robot (50) is present;

first robot-feeding error detecting means (70) configured to detect first robot-feeding errors, which are feeding errors of the first robot (20) rotative to the body (1) in the X direction and the Y direction, on the basis of reference marks (91) on a reference plate (90) disposed on the body (1) that are imaged by the imaging device (40);

relative position detecting means (70) configured to move the first and second robots (20, 50) to inspection positions (201) in the X direction and the Y direction and to detect relative position errors of the first and second robots (20, 50) in the X direction and the Y direction on the basis of the inspection mark (61) that is imaged at the inspection positions (201) by the imaging device (40); and

second robot-feeding error detecting means (70) configured to detect second robot-feeding errors, which are feeding errors of the second robot (50) relative to the body (1) in the X direction and the Y direction, on the basis of the first robot-feeding errors and the relative position errors.

2. The work apparatus (100) according to claim 1,
wherein the inspection positions (201) are grid points (201) on a plane parallel to the X direction and the Y direction, the relative position detecting means (70) is configured to detect the relative position errors at a plurality of grid points (201) among all the grid points (201), and
the second robot-feeding error detecting means (70) is configured to detect the second robot-feeding errors on the basis of a plurality of the relative position errors that are detected at the plurality of grid points (201).

3. The work apparatus (100) according to claim 1,
wherein the relative position detecting means (70) is configured to detect the relative position errors at a work position (301) of the second work device (60) that is mounted on the second robot (50), and
the second robot-feeding error detecting means (70) is configured to detect the second robot-feeding errors on the basis of the relative position errors that are detected at the work position (301).

4. The work apparatus (100) according to any one of claims 1 to 3,
wherein the reference marks (91) are marks that are formed in the shape of grid points on a surface of a reference plate (90) disposed on the body (1) in parallel to the X direction and the Y direction, and
the first robot-feeding error detecting means (70) is configured to detect the first robot-feeding errors on the basis of information about the positions of the plurality of reference marks (91) among all the reference marks (91).


**Patentansprüche**

1. Eine Arbeitsvorrichtung (100), umfassend:

einen Körper (1);

einen ersten Roboter (20), der an dem Körper (1) so vorgesehen ist, dass er in einer X-Richtung und einer Y-Richtung, die orthogonal zueinander sind, bewegbar ist, wobei eine erste Arbeitsvorrichtung (30) an dem ersten Roboter (20) angebracht ist;

einen zweiten Roboter (50), der an dem Körper (1) an einer Position, die sich von einer Position des ersten Roboters (20) in einer Z-Richtung orthogonal zu der X-Richtung und der Y-Richtung unterscheidet, so bereitgestellt ist, dass er in der X-Richtung und der Y-Richtung bewegbar ist, wobei eine zweite Arbeitsvorrichtung (60) an dem zweiten Roboter (50) angebracht ist,

wobei die zweite Arbeitsvorrichtung (60) konfiguriert ist, im Vergleich zu der ersten Arbeitsvorrichtung (30) Arbeit auf einer gegenüberliegenden Seite von einer Platte, die von der Arbeitsvorrichtung (100) gehalten wird, auszuführen;

**gekennzeichnet durch**

eine Inspektionsmarkierung (61), die an dem zweiten Roboter (50) oder der zweiten Arbeitsvorrichtung (60), die an dem zweiten Roboter (50) angebracht ist, vorgesehen ist;

eine Abbildungsvorrichtung (40), die an dem ersten Roboter (20) bereitgestellt ist und eine Seite abbildet, auf der der zweite Roboter (50) vorhanden ist;

eine erste Roboterzuführfehler-Erfassungseinrichtung (70), die konfiguriert ist, erste Roboterzuführfehler, welches Zuführfehler des ersten Roboters (20) bezüglich des Körpers (1) in der X-Richtung und der Y-Richtung sind, auf Basis von Referenzmarkierungen (91) auf einer an dem Körper (1) angeordneten Referenzplatte (90) zu detektieren, welche von der Abbildungsvorrichtung (40) abgebildet werden;

eine Relativpositions-Erfassungseinrichtung (70), die konfiguriert ist, den ersten und zweiten Roboter (20, 50) zu Inspektionspositionen (201) in der X-Richtung und der Y-Richtung zu bewegen und Relativpositionsfehler des ersten und zweiten Roboters (20, 50) in der X-Richtung und der Y-Richtung auf der Basis der Inspektionsmarkierung (61), die an den Inspektionspositionen (201) von der Abbildungsvorrichtung (40) abgebildet wird, zu detektieren; und

eine zweite Roboterzuführfehler-Erfassungseinrichtung (70), die konfiguriert ist, zweite Roboterzuführfehler, die Zuführfehler des zweiten Roboters (50) relativ zu dem Körper (1) in der X-Richtung und der Y-Richtung sind, auf der Basis der ersten Roboterzuführfehler und der Relativpositionsfehler zu detektieren.

2. Die Arbeitsvorrichtung (100) gemäß Anspruch 1,
wobei die Inspektionspositionen (201) Gitterpunkte (201) auf einer zu der X-Richtung und der Y-Richtung parallelen Ebene sind,
die Relativpositions-Erfassungseinrichtung (70) konfiguriert ist, die Relativpositionsfehler an einer Vielzahl von Gitterpunkten (201) von all den Gitterpunkten (201) zu detektieren, und
die zweite Roboterzuführfehler-Erfassungseinrichtung (70) konfiguriert ist, die zweiten Roboterzuführfehler auf der Basis einer Vielzahl der Relativpositionsfehler zu detektieren, die an der Vielzahl von Gitterpunkten (201) detektiert werden.

3. Die Arbeitsvorrichtung (100) gemäß Anspruch 1,
wobei die Relativpositions-Erfassungseinrichtung (70) konfiguriert ist, die Relativpositionsfehler an einer Arbeitsposition (301) der zweiten Arbeitsvorrichtung (60), die an dem zweiten Roboter (50) angebracht ist, zu detektieren, und
die zweite Roboterzuführfehler-Erfassungseinrichtung (70) konfiguriert ist, die zweiten Roboterzuführfehler auf der Basis der Relativpositionsfehler, die an der Arbeitsposition (301) detektiert werden, zu detektieren.

4. Die Arbeitsvorrichtung (100) gemäß einem der Ansprüche 1 bis 3,
wobei die Referenzmarkierungen (91) Markierungen sind, die in der Form von Gitterpunkten auf einer Oberfläche einer an dem Körper (1) parallel zu der X-Richtung und der Y-Richtung angeordneten Referenzplatte (90) sind, und
die erste Roboterzuführfehler-Erfassungseinrichtung (70) konfiguriert ist, die ersten Roboterzuführfehler auf der Basis von Informationen über die Positionen der Vielzahl von Referenzmarkierungen (91) von all den Referenzmarkierungen (91) zu detektieren.

**Revendications**

1. Appareil de travail (100) comprenant :

un corps (1) ;
un premier robot (20) qui est situé sur le corps (1) de manière à être mobile dans une direction X et une direction Y orthogonales l'une par rapport à l'autre, dans lequel un premier dispositif de travail (30) est monté sur le premier robot (20) ;
un second robot (50) qui est situé sur le corps (1) à une position différente d'une position du premier robot (20) dans une direction Z orthogonale à la direction X et à la direction Y, de manière à être mobile dans la direction X et la direction Y, dans lequel un second dispositif de travail (60) est monté sur le second robot (50),
dans lequel le second dispositif de travail (60) est conçu pour réaliser une tâche sur un côté opposé d'une plaque maintenue par l'appareil de travail (100) par rapport au premier dispositif de travail (30) ;
**caractérisé par**
une marque d'inspection (61) qui est située sur le second robot (50) ou le second dispositif de travail (60) monté sur le second robot (50) ;
un dispositif de formation d'image (40) qui est situé sur le premier robot (20) et produit une image d'un côté où se trouve le second robot (50) ;
un moyen (70) de détection d'erreur d'avance du premier robot conçu pour détecter des erreurs d'avance du premier robot, qui sont des erreurs d'avance du premier robot (20) par rapport au corps (1) dans la direction X et la direction Y, sur la base de marques de référence (91) présentes sur une plaque de référence (90) disposée sur le corps (1) et dont une image est produite par le dispositif de formation d'image (40) ;
un moyen (70) de détection de position relative conçu pour déplacer les premier et second robots (20, 50) vers des positions d'inspection (201) dans la direction X et la direction Y et pour détecter des erreurs de position relative des premier et second robots (20, 50) dans la direction X et la direction Y sur la base de la marque d'inspection (61) dont une image est produite aux positions d'inspection (201) par le dispositif de formation d'image (40) ; et

un moyen (70) de détection d'erreur d'avance du second robot conçu pour détecter des erreurs d'avance du second robot, qui sont des erreurs d'avance du second robot (50) par rapport au corps (1) dans la direction X et la direction Y, sur la base des erreurs d'avance du premier robot et des erreurs de position relative.

2.  Appareil de travail (100) selon la revendication 1,

dans lequel les positions d'inspection (201) sont des points de grille (201) sur un plan parallèle à la direction X et à la direction Y,

le moyen (70) de détection de position relative est conçu pour détecter les erreurs de position relative au niveau d'une pluralité de points de grille (201) parmi tous les points de grille (201), et

le moyen (70) de détection d'erreur d'avance du second robot est conçu pour détecter les erreurs d'avance du second robot sur la base d'une pluralité des erreurs de position relative qui sont détectées au niveau de la pluralité des points de grille (201).

3.  Appareil de travail (100) selon la revendication 1,

dans lequel le moyen (70) de détection de position relative est conçu pour détecter les erreurs de position relative au niveau d'une position de travail (301) du second dispositif de travail (60) qui est monté sur le second robot (50), et

le moyen (70) détection d'erreur d'avance du second robot est conçu pour détecter les erreurs d'avance du second robot sur la base des erreurs de position relative qui sont détectées au niveau de la position de travail (301).

4.  Appareil de travail (100) selon l'une quelconque des revendications 1 à 3,

dans lequel les marques de référence (91) sont des marques qui sont réalisées sous la forme de points de grille sur une surface d'une plaque de référence (90) disposée sur le corps (1) parallèlement à la direction X et à la direction Y, et

le moyen (70) de détection d'erreur d'avance du premier robot est conçu pour détecter les erreurs d'avance du premier robot sur la base d'informations relatives aux positions de la pluralité de marques de référence (91) parmi toutes les marques de référence (91).

FIG. 1

FIG. 2

VIEW SEEN IN DIRECTION OF ARROW A

# FIG. 3

# FIG. 4

```
┌──────────────────────────────────────────┐
│  FEEDING ERROR DETECTION PROCESSING      │
└──────────────────────────────────────────┘
                     │
                     ▼
         ┌───────────────────────┐
         │  ACQUIRE BODY ORIGIN  │──S11
         └───────────────────────┘
                     │
                     ▼
        ┌─────────────────────────┐
        │ DISPOSE REFERENCE PLATE │──S12
        └─────────────────────────┘
                     │
                     ▼
        ┌──────────────────────────┐
        │ PERFORM MATRIX CORRECTION│──S13
        └──────────────────────────┘
                     │
                     ▼
                  ◇ IS
           MATRIX CORRECTION ────S14 NO
              COMPLETED?
                     │ YES
                     ▼
        ┌──────────────────────────┐
        │ PERFORM NORMAL CALIBRATION│──S15
        └──────────────────────────┘
                     │
                     ▼
                  ◇ IS
          NORMAL CALIBRATION ────S16 NO
              COMPLETED?
                     │
                     ▼
                  ◇ IS
            HIGHLY ACCURATE ────S17 NO
              POSITIONING
              NECESSARY?
                     │ YES
                     ▼
        ┌──────────────────────────┐
        │  PERFORM FINE CALIBRATION│──S18
        └──────────────────────────┘
                     │
                     ▼
                  ◇ IS
           FINE CALIBRATION ────S19 NO
              COMPLETED?
                     │ YES
                     ▼
         ┌───────────────────────┐
         │          END          │
         └───────────────────────┘
```

EP 2 894 012 B1

FIG. 5

90

91

Y

X

17

# FIG. 6

(A)

(B)

POSITION OF REFERENCE
MARK WHEN POSITION
ERRORS DO NOT ARISE ON
REFERENCE PLATE

IMAGING CENTER
OF IMAGING
DEVICE

ACTUAL POSITION OF
REFERENCE MARK

# FIG. 7

# FIG. 8

(A)

X →

INSTRUCTION VALUE

ACTUAL POSITION OF UPPER ROBOT IN X DIRECTION

UPPER ROBOT-FEEDING ERROR (X DIRECTION)

ACTUAL POSITION OF UPPER ROBOT IN X DIRECTION

ACTUAL POSITION OF LOWER ROBOT IN X DIRECTION

RELATIVE POSITION ERROR (X1, Y1)

(B)

UPPER ROBOT-FEEDING ERROR (X DIRECTION)

RELATIVE POSITION ERROR (X1, Y1)

LOWER ROBOT-FEEDING ERROR (X1, Y1)

(C)

ACTUAL POSITION OF UPPER ROBOT IN X DIRECTION

INSTRUCTION VALUE

UPPER ROBOT-FEEDING ERROR (X DIRECTION)

ACTUAL POSITION OF LOWER ROBOT IN X DIRECTION

ACTUAL POSITION OF UPPER ROBOT IN X DIRECTION

RELATIVE POSITION ERROR (X1, Y1)

(D)

UPPER ROBOT-FEEDING ERROR (X DIRECTION)

RELATIVE POSITION ERROR (X1, Y1)

LOWER ROBOT-FEEDING ERROR (X1, Y1)

**EP 2 894 012 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3247703 B

- DE 3805784 A1